# EUROPEAN PATENT APPLICATION

(11) **EP 2 608 278 A1**
(43) Date of publication of application: **26.06.2013**
(21) Application number: 12188049.6
(22) Date of filing: 10.10.2012
(51) Int. Cl.: H01L 31/052, H01L 31/058

(54) **Solar cell module**

(30) Priority: 21.12.2011 TW 100147755
(71) Applicant: Industrial Technology Research Institute, Chutung Hsinchu 31040 (TW)
(72) Inventor: Lin, Hui-Hsiung, 351 Miaoli County (TW); Liao, Chi-Hung, 700 Tainan City, (TW); Lin, Chun-Ting, 241 New Taipei City, (TW); Wu, Tsung-Cho, 812 Kaohsiung City, (TW); Yang, Wen-Hsun, 106 Taipei City, (TW)
(74) Representative: Becker Kurig Straus

(57) **Abstract**

A solar cell module is provided, including a solar collector, a solar cell chip panel and a cooling pipeline system. The solar collector includes a first optical surface and a second optical surface, wherein light enters the solar collector from the first optical surface, and then exits from the second optical surface after collection. The solar cell chip panel has a light-receiving surface for receiving the light exited from the second optical surface. The solar cell chip panel includes a photovoltaic conversion material capable of absorbing a specific spectrum band in the light and converting that into electricity. The cooling pipeline system allows water to flow therein and includes a heat absorber, wherein the light exits to the light-receiving surface of the solar cell chip panel through the heat absorber, and the water flowing through the heat absorber absorbs light beyond the specific spectrum band.

## Description

### CROSS-REFERENCE TO RELATED APPLICATION

This application claims the priority benefit of Taiwan application serial no. 100147755, filed on December 21, 2011. The entirety of the above-mentioned patent application is hereby incorporated by reference herein and made a part of this specification.

### BACKGROUND

### Technical Field

The technical field relates to a solar cell module, and more particularly to a solar cell module with an enhanced power generation efficiency.

### Related Art

In the modem age of globalization, using emerging energy sources and energy saving green technologies have become the focus for many people. Among these energy sources, solar energy is an inexhaustible energy free of pollution. Therefore, when faced with issues such as pollution and energy shortage derived from fossil fuels, the photovoltaic converting and energy saving technologies related to solar energy generation have become the primary concern. Since the solar cell can be used to directly convert solar energy into electrical energy, the solar cell has become the focus of current development in utilizing solar energy.

In order to lower the cost of the expensive solar cell, many experts have begun to investigate the solar collector. However, using the solar cell causes a rapid increase in the solar cell temperature and instead lowers the power generation efficiency. Moreover, the photovoltaic conversion efficiency for a typical solar cell chip made of silicon-based materials is limited. Therefore, most of the sunlight irradiated on the solar cell chip is wasted. Since a majority of sunlight irradiated on the solar cell chip is not converted to electricity, the wavelength of light which cannot be converted by the solar cell chip is transformed into heat on the solar cell chip. Accordingly, the solar cell chip may be overheated, thereby causing the reduction in the power generation efficiency.

### SUMMARY

The disclosure provides a solar cell module capable of simultaneously achieving solar chip heat dissipation and the reuse of the heat circulation, thereby enhancing the solar power generation efficiency.

The disclosure provides a solar cell module, including a solar collector, a solar cell chip panel, and a cooling pipeline system. The solar collector includes a first optical surface and a second optical surface, in which a light enters the solar collector from the first optical surface, and then exits from the second optical surface after collection. The solar cell chip panel has a light-receiving surface for receiving the light exited from the second optical surface. The solar cell chip panel includes a photovoltaic conversion material absorbing a specific spectrum band in the light and converting that into electricity. The cooling pipeline system allows water to flow therein, and includes a heat absorber, in which the light exits to the light-receiving surface of the solar cell chip panel through the heat absorber, and the water flowing through the heat absorber absorbs light beyond the specific spectrum band.

According to an exemplary embodiment, the heat absorber is disposed between the second optical surface of the solar collector and the light-receiving surface of the solar cell chip panel, so the light exits to the light-receiving surface from the second optical surface after passing through the heat absorber.

According to an exemplary embodiment, the heat absorber is disposed external to a space between the second optical surface of the solar collector and the light-receiving surface, so the light enters the first optical surface after passing through the heat absorber.

According to an exemplary embodiment, the heat absorber is disposed at a plane on a same side of the first optical surface of the solar collector.

According to an exemplary embodiment, the plane is perpendicular to the light-receiving surface and parallel to the first optical surface.

According to an exemplary embodiment, the photovoltaic conversion material includes single crystal silicon, polysilicon, or amorphous silicon, and when the photovoltaic conversion material is a silicon-based material, the specific spectrum band is between 300 nm to 1107 nm.

According to an exemplary embodiment, a material of the heat absorber is a material allowing light of the specific spectrum band to transmit.

According to an exemplary embodiment, the cooling pipeline system includes a first channel, a second channel, and a storage tank. The first channel is disposed on a side facing away from the light-receiving surface of the solar cell chip panel. The second channel is connected to the heat absorber and to the first channel. The storage tank is connected to the first channel and the second channel to form a loop, in which after water having a first temperature flows from the storage tank through the first channel, the second channel, and the heat absorber in sequence, the water reflows into the storage tank and has a second temperature that is higher than the first temperature. A material of the first channel includes a material with a coefficient of thermal conductivity of greater than 35 W/mK. In one embodiment, the first channel includes a metal pipe, such as a copper pipe. The storage tank is a heat insulating storage tank storing the water after the temperature increase.

According to an exemplary embodiment, the cooling pipeline system further includes a pump providing a power for the water flow.

According to an exemplary embodiment, an area of the first optical surface is greater than an area of the second optical surface.

According to an exemplary embodiment, the first optical surface is adjacent to the second optical surface.

The disclosure provides another solar cell module, including a solar collector, a solar cell chip panel, a light filter interface, and a cooling pipeline system. The solar collector includes a first optical surface, a second optical surface, and a third optical surface, in which a light enters the solar collector from the first optical surface, and then exits from the second optical surface after collection. The solar cell chip panel has a light-receiving surface for receiving the light exited from the second optical surface. The solar cell chip panel includes a photovoltaic conversion material absorbing a specific spectrum band in the light and converting that into electricity. The light filter interface is disposed on the third optical surface, allowing light beyond the specific spectrum band to transmit the third optical surface. The cooling pipeline system allows water to flow therein, and includes a heat absorber, in which the light filter interface is disposed between the third optical surface and the heat absorber, and the water flowing through the heat absorber absorbs light beyond the specific spectrum band.

According to an exemplary embodiment, the light filter interface includes a coated film or a plurality of microstructures.

According to an exemplary embodiment, the solar cell module further includes a heat conduction plate disposed between the light filter interface and the heat absorber. The heat conduction plate is a black coated plate, for example. In one embodiment, a material of the heat conduction plate includes a material with a coefficient of thermal conductivity of greater than 35 W/mK. In one embodiment, a material of the heat conduction plate includes a metal plate.

According to an exemplary embodiment, the photovoltaic conversion material includes single crystal silicon, polysilicon, or amorphous silicon, and when the photovoltaic conversion material is a silicon-based material, the specific spectrum band is between 300 nm to 1107 nm.

According to an exemplary embodiment, the heat absorber includes a plurality of channels.

According to an exemplary embodiment, a material of the heat absorber includes a material with a coefficient of thermal conductivity of greater than 35 W/mK.

According to an exemplary embodiment, a material of the heat absorber includes a metal, such as copper.

According to an exemplary embodiment, the cooling pipeline system includes a first channel, a second channel, and a storage tank. The first channel is disposed on a side facing away from the light-receiving surface of the solar cell chip panel. The second channel is connected to the heat absorber and to the first channel. The storage tank is connected to the first channel and the second channel to form a loop, in which after water having a first temperature flows from the storage tank through the first channel, the second channel, and the heat absorber in sequence, the water reflows into the storage tank and has a second temperature that is higher than the first temperature. A material of the first channel includes a material with a coefficient of thermal conductivity of greater than 35 W/mK. In one embodiment, the first channel includes a metal pipe, such as a copper pipe. The storage tank is a heat insulating storage tank storing the water after the temperature increase.

According to an exemplary embodiment, the cooling pipeline system further includes a pump providing a power for the water flow.

According to an exemplary embodiment, an area of the first optical surface and an area of the third optical surface are greater than an area of the second optical surface.

According to an exemplary embodiment, the first optical surface is adjacent to the second optical surface, the second optical surface is adjacent to the third optical surface, and the first optical surface and the third optical surface are disposed opposite to each other.

In summary, in the solar cell modules of the embodiments in the disclosure, the water flowing through the heat absorber in the cooling pipeline system is utilized to absorb the energy beyond the specific spectrum band which cannot be absorbed by the photovoltaic conversion material, and this energy is transferred to the water to increase the water temperature. Accordingly, not only is the temperature of the solar cell chip panel lowered so as to increase the power generation efficiency of the solar cell chip, but at the same time, the heat circulation can be reused.

Several exemplary embodiments accompanied with figures are described in detail below to further describe the disclosure in details.

### BRIEF DESCRIPTION OF THE DRAWINGS

The accompanying drawings constituting a part of this specification are incorporated herein to provide a further understanding of the disclosure. Here, the drawings illustrate embodiments of the disclosure and, together with the description, serve to explain the principles of the disclosure.

FIG. 1 is a schematic perspective view of a solar cell module according to a first embodiment of the disclosure.

FIG. 2 is an absorption spectrum diagram of a polysilicon solar cell.

FIG. 3 is a solar spectrum diagram.

FIG. 4 is an absorption spectrum diagram of water.

FIG. 5 is a schematic perspective view of a solar cell module according to a second embodiment of the disclosure.

FIG. 6A is a schematic perspective view of a solar cell module according to a third embodiment of the disclosure.

FIG. 6B is a partial perspective assembly view of a solar cell module from another angle.

FIG. 7 is a transmittance curve diagram of a longpass filter according to an illustrative example.

FIG. 8 is a cooling pipeline system used in an experimental example of the disclosure, in which an electric heater is used to simulate the heating of the solar cell chip panel.

### DESCRIPTION OF EMBODIMENTS

Typically speaking, not all the wavelength of light energy can be converted into electric energy, and consequently, a majority of solar energy entering the solar cell is wasted and becomes unusable heat. The wavelength of sunlight capable of generating the photovoltaic effect is related to the band gap of the solar cell chip material. In other words, not only is the energy beyond the band gap of the photovoltaic conversion material unable to be converted by the solar cell chip into electricity, this energy causes the temperature of the chip to rise, thereby lowering the power generation efficiency of the solar cell. For example, not only the polysilicon solar cells cannot convert solar energy in the sunlight beyond a wavelength of 1107 run into electricity, but the power generation efficiency of the polysilicon solar cell is reduced.

Accordingly, a solar cell module provided by the embodiments of the disclosure absorbs the energy of a wavelength of sunlight beyond the band gap of the solar cell chip material, so as to lower the chip temperature, increase the power generation efficiency, and thereby mitigate the issue of overheat in the chip after the collection of the sunlight. Moreover, after absorbing the wavelength of sunlight that cannot be converted by the solar cell chip into electricity, the energy is transferred to water for providing hot water. Therefore, the solar cell module provided by the embodiments of the disclosure can effectively utilize the energy of the entire solar spectrum and convert that energy into electricity and heat, so as to achieve the effect of power savings.

Referring to the drawings attached, the disclosure will be described by means of the embodiments below. Nevertheless, the disclosure may be embodied in many different forms and should not be construed as limited to the embodiments set forth herein. The language used to describe the directions such as up, down, left, right, front, back or the like in the reference drawings is regarded in an illustrative rather than in a restrictive sense. For the purpose of clarity, the sizes and relative sizes of each of the layers in the drawings may be illustrated in exaggerated proportions.

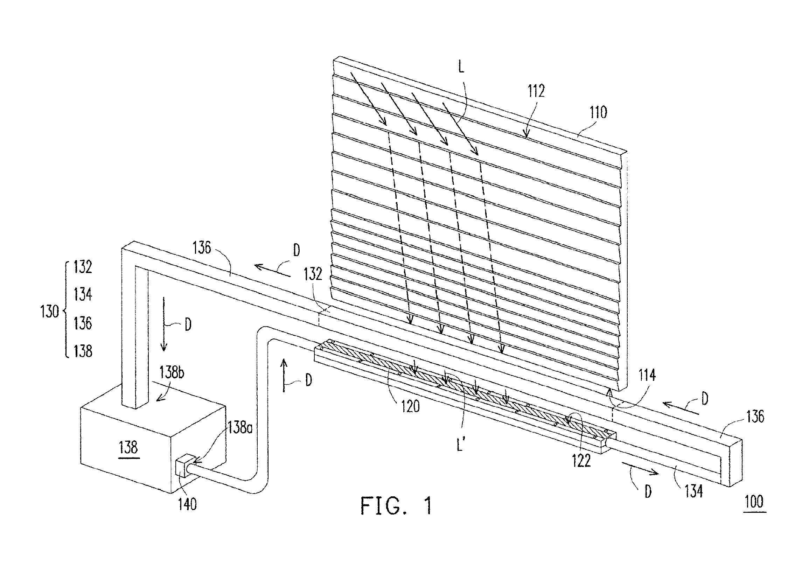

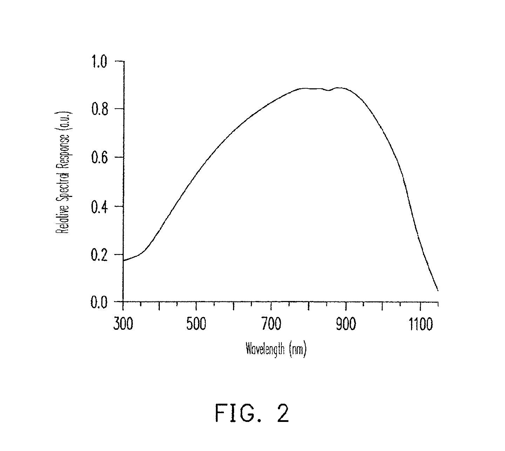

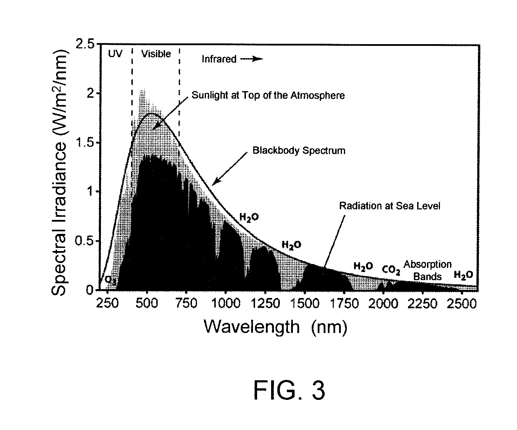

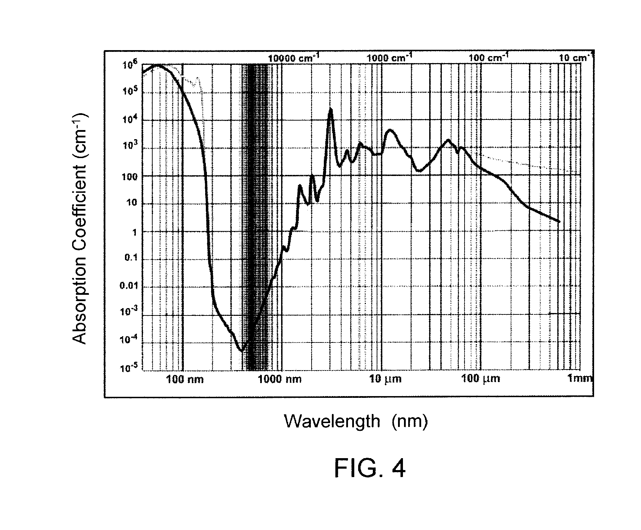

FIG. 1 is a schematic perspective view of a solar cell module according to a first embodiment of the disclosure. FIG. 2 is an absorption spectrum diagram of a polysilicon solar cell. FIG. 3 is a solar spectrum diagram. FIG. 4 is an absorption spectrum diagram of water.

Referring to FIG. 1, a solar cell module 100 includes a solar collector 110, a solar cell chip panel 120, and a cooling pipeline system 130.

The solar collector 110 includes a first optical surface 112 and a second optical surface 114, in which a light L enters the solar collector 110 from the first optical surface 112, and then exits from the second optical surface 114 after collection. The first optical surface 112 is, for example, adjacent to the second optical surface 114. An area of the first optical surface 112 is, for example, greater than an area of the second optical surface 114. The solar collector 110 is a nanoscale deflector film fabricated by roll-to-roll ultra-precision machining, for example, capable of effectively deflect the light L to a designed angle, so as to enhance a light collection efficiency.

The solar cell chip panel 120 has a light-receiving surface 122 for receiving the light L exited from the second optical surface 114 of the solar collector 110. By using the solar collector 110, a light energy collection ratio per unit area can be increased. Therefore, the solar cell chip panel 120 can effectively receive the light L deflected from the solar collector 110. Accordingly, the area and the cost of the solar cell chip can be lowered. For example, the solar cell chip panel 120 may be formed by a plurality of solar cell chips connected in series or parallel. Each of the solar cell chips includes a substrate, a front contact and a back contact disposed above the substrate, and a photovoltaic conversion material disposed between the two contacts. The photovoltaic conversion material serves as an active layer for absorbing a specific spectrum band in the light L and converting light energy into electricity. In one embodiment, a band gap of the photovoltaic conversion material under room temperature, for example single crystal silicon, polysilicon, or amorphous silicon, is approximately 1.12 eV. Moreover, the disclosure does not specifically limit the type, structure, or components of the solar cell chip panel 120, and those skilled in the art would adjust according to the requirements, so further elaboration thereof is omitted hereafter.

The cooling pipeline system 130 allows water to flow therein, and includes a heat absorber 132, a first channel 134, a second channel 136, and a storage tank 138 connected in series, for example.

The heat absorber 132 is connected to the second channel 136, and the water flowing through the heat absorber 132 may absorb light beyond the specific spectrum band absorbable by the photovoltaic conversion material. In one embodiment, the heat absorber 132 is disposed between the second optical surface 114 of the solar collector 110 and the light-receiving surface 122 of the solar cell chip panel 120. Consequently, the light L exits to the light-receiving surface 122 from the second optical surface 114 after passing through the heat absorber 132. The heat absorber 132 and the second channel 136 are connected by an integrated form, for example. As shown in FIG. 1, the heat absorber 132 is, for example, a part of the second channel 136. In other words, the heat absorber 132 may be a partial segment of the second channel 136 disposed between the second optical surface 114 and the light-receiving surface 122. The heat absorber 132 is made of a material allowing the specific spectrum band of light to transmit, such as transparent glass, plastic, or acrylic, for example.

Accordingly, the water flowing through the heat absorber 132 can absorb the energy in the wavelength of sunlight L exiting after collection which cannot be absorbed by the solar cell chip panel 120. On the other hand, a residue light L' enters into the solar cell chip panel 120 for generating electricity. Therefore, the portion of wavelength in the sunlight L generating heat is absorbed by the water flowing through the heat absorber 132 before becoming incident on the solar cell chip panel 120. Consequently, the temperature of the solar cell chip panel 120 can be effectively lowered, and the power generation efficiency can be increased.

As described above, the first channel 134 is disposed on a side facing away from the light-receiving surface 122 of the solar cell chip panel 120, for example below the solar cell chip panel 120. The first channel 134 is, for example, tightly attached to the back of the solar cell chip panel 120, or a thermal grease with high thermal conductivity is filled between the first channel 134 and the solar cell chip panel 120, so as to effectively utilize the comparatively lower temperature water in the first channel 134 to absorb the excess heat on the solar cell chip panel 120. A material of the first channel 134 includes a material with a high coefficient of thermal conductivity, such as a material with a coefficient of thermal conductivity of greater than 35 W/mK. In one embodiment, the first channel 134 includes a metal pipe, such as a copper pipe, for example. The second channel 136 is connected to the first channel 134. In this embodiment, since the heat absorber 132 and the second channel 136 are, for example, integrally formed, a material of the second channel 136 may be the same as the material of the heat absorber 132. The storage tank 138 is connected to the first channel 134 and the second channel 136 to form a loop. The storage tank 138 is, for example, a thermal insulating liquid storage tank storing the water after the temperature increase.

It should be noted that, after water having a first temperature flows in a flow direction D from the storage tank 138 through the first channel 134, the second channel 136, and the heat absorber 132 in sequence, the water reflows into the storage tank 138 and has a second temperature that is higher than the first temperature. For example, the cooling pipeline system 130 may further include a pump 140 providing a power for the water flow, and to guide the comparatively low temperature water to flow from an outlet 138a of the storage tank 138 into the first channel 134. Accordingly, the water flows in the first channel 134, the second channel 136, and the heat absorber 132 along the flow direction D. By having the water first flow through the first channel 134 to absorb the residue heat of the solar cell chip panel 120, and thereafter having the water flow through the heat absorber 132 to absorb the energy from the wavelength of sunlight beyond the specific spectrum band range absorbable by the photovoltaic conversion material, in this process the water is heated and the water temperature rises, so the water with the absorbed heat and the increased temperature flows from an inlet 138b into the storage tank 138 along the flow direction D.

It should be mentioned that, in the solar cell chip panel 120, the specific spectrum band absorbable by the photovoltaic conversion material typically is determined by the properties of the photovoltaic conversion material. In other words, not all the wavelength of light energy can be converted into electricity, and therefore a majority of sunlight entering the solar cell becomes wasted and unusable heat. The wavelength of sunlight capable of allowing the solar cell chip to generate the photovoltaic effect is related to the band gap of the material of the solar cell chip. For example, when the photovoltaic conversion material is a silicon-based material, the band gap of the material is approximately 1.12 eV under room temperature, and the absorbable specific spectrum band is between 300 nm to 1107 nm. Referring to FIG. 2, it's difficult for the polysilicon solar cell converting energy beyond a wavelength of 1107 nm into electricity. Moreover, the solar energy spectrum of wavelength longer than 1107 nm would instead cause the temperature of the polysilicon solar cell to rise, and thereby lower the power generation efficiency of the polysilicon solar cell. As shown in FIG. 3, in the solar spectrum diagram, the solar spectral energy of a wavelength longer than 1107 nm occupies approximately 20% of the entire solar spectral energy, which causes the temperature of the silicon-based solar cell to rise and the reduction of the power generation efficiency.

It should be noted that, referring to FIG. 4, water has a high absorption coefficient for light of wavelength longer than 1000 nm, and the absorption coefficient of water is especially preferable for light of wavelength longer than 1107 nm. Therefore, by using the cooling pipeline system 130 connected in series, the water flowing through the first channel 134 is able to not only carry away the heat of the chip, but by having the water flow through the heat absorber 132, the solar spectral energy in the solar spectrum which cannot be converted into electricity is absorbed and transformed in the water. Accordingly, the temperature of the solar cell chip panel 120 can be controlled, thereby effectively increasing the power generation efficiency of the solar cell chip panel 120.

Moreover, when a silicon-based photovoltaic conversion material which cannot absorb wavelength beyond 1107 nm is selected, and water is used as a heat absorbing liquid circulating in the cooling pipeline system 130, then after the water flows through the series-connected pipeline and absorbs the heat and the infrared radiation, the water temperature rises and the water is collected in the heat insulating storage tank 138. Therefore, the storage tank 138 can provide hot water stored therein for direct use by an inhabitant. Accordingly, not only can the solar cell module 100 maintain the low temperature and high efficiency operating conditions of the solar cell chip panel 120, but at the same time, the residue heat is reused with further heat circulation. Therefore, the solar cell module 100 can effectively utilize the light energy and heat of the sun. Hence, the solar cell module provided by the present embodiment can effectively utilize the energy of the entire solar spectrum and convert that energy into electricity and heat, so as to achieve the effect of power savings.

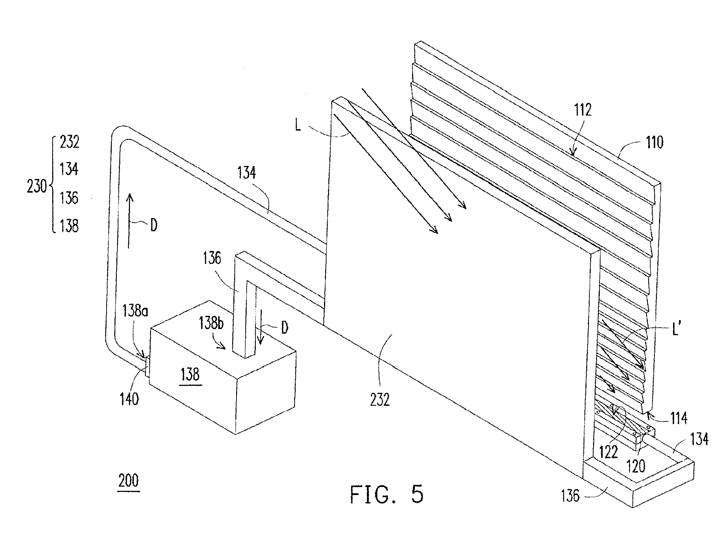

FIG. 5 is a schematic perspective view of a solar cell module according to a second embodiment of the disclosure. It should be noted that, in FIG. 5, identical reference numerals are used for the same elements as those in FIG. 1, and description of those elements is omitted.

Referring to FIG. 5, in the present embodiment, the main components constituting a solar cell module 200 illustrated in FIG. 5 are generally identical to those constituting the solar cell module 100 depicted in FIG. 1. However, a difference between the two solar cell modules lies mainly in the position and the form of the heat absorber. In one embodiment, a heat absorber 232 in a cooling pipeline system 230 is connected to the second channel 136. Moreover, the heat absorber 232 is disposed external to a space between the second optical surface 114 of the first optical surface 112 in the solar collector 110 and the light-receiving surface 122, so the light L enters the first optical surface 112 after passing through the heat absorber 232. The heat absorber 232 is, for example, disposed at a plane on a same side of the first optical surface 112 of the solar collector 110. The plane is, for example, perpendicular to the light-receiving surface 122 and parallel to the first optical surface 112, such as in front of the first optical surface 112, for instance. In other words, the heat absorber 232 is, for example, disposed in front of the first optical surface 112 of the solar collector 110 as a front mask. The heat absorber 232 is made of a material allowing the specific spectrum band of light to transmit, such as transparent glass, plastic, or acrylic, for example. The heat absorber 232 and the second channel 136 may be connected by an integrated form, or attached by using respectively different materials, and the disclosure is not specifically limited thereto.

In specifics, the sunlight L first passes through the heat absorber 232 serving as the front mask, and the energy from the wavelength of sunlight beyond the specific spectrum band absorbable by the photovoltaic conversion material is transferred to the water of the heat absorber 232. Thereafter, the residue light L' transmitting through the heat absorber 232 enters the solar collector 110 from the first optical surface 112, then exits from the second optical surface 114 after collection to the light-receiving surface 122 of the solar cell chip panel 120, so as to generate electricity by the photovoltaic conversion process.

Although the embodiment depicted in FIG. 5 configures the water to flow inside the entire panel body to be the heat absorber 232 as an illustrative example, the disclosure is not limited thereto. In other embodiments, the heat absorber 232 may also be a large area water circulating pipeline formed by a plurality of connecting channels, so long as the sunlight L first transmits the heat absorber 232 then enters the solar collector 110.

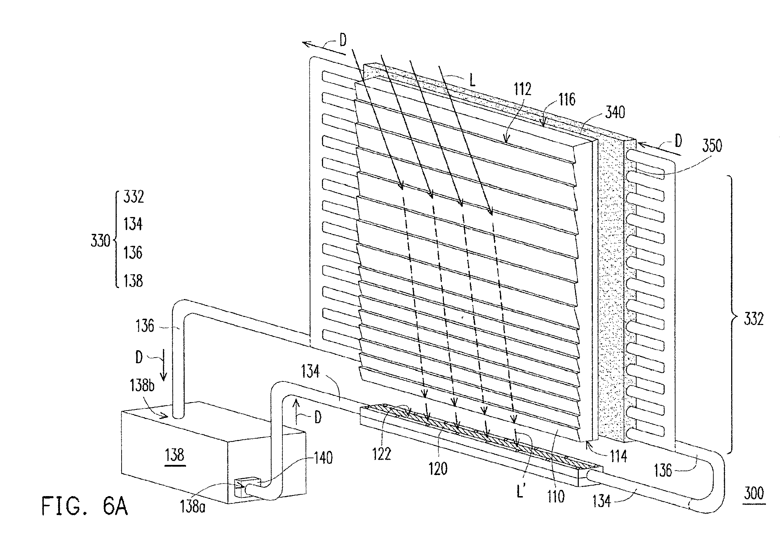

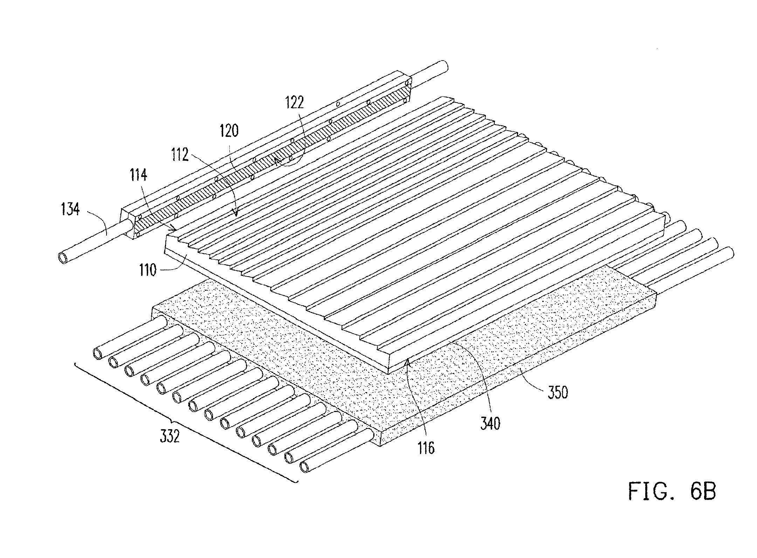

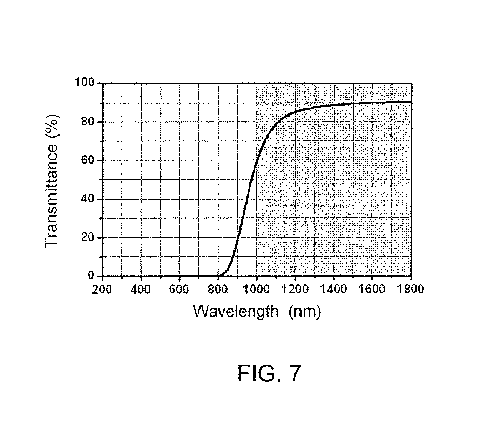

FIG. 6A is a schematic perspective view of a solar cell module according to a third embodiment of the disclosure. FIG. 6B is a partial perspective assembly view of a solar cell module from another angle according to an embodiment of the disclosure. FIG. 7 is a transmittance curve diagram of a longpass filter according to an illustrative example. It should be noted that, in FIGs. 6A and 6B, identical reference numerals are used for the same elements as those in FIG. 1, and description of those elements is omitted.

Referring to FIG. 6A, in the present embodiment, the main components constituting a solar cell module 300 illustrated in FIG. 6A are generally identical to those constituting the solar cell module 100 depicted in FIG. 1. However, a difference between the two solar cell modules lies mainly in that, the solar cell module 100 directly uses the water flowing through the heat absorber 132 to absorb the energy from the wavelength of sunlight beyond the specific spectrum band absorbable by the photovoltaic conversion material. On the other hand, the solar cell module 300 first employs a light filter interface 340 to filter the wavelength beyond the specific spectrum band, then uses the water flowing through a heat absorber 332 in a cooling pipeline system 330 for heat absorption.

As shown in FIGs. 6A and 6B, the solar cell module 300 includes the solar collector 110, the solar cell chip module 120, the light filter interface 340, and the cooling pipeline system 330. The solar collector 110 includes the first optical surface 112, the second optical surface 114, and a third optical surface 116. The first optical surface 112 is, for example, adjacent to the second optical surface 114. The second optical surface 114 is, for example, adjacent to the third optical surface 116. The first optical surface 112 and the third optical surface 116 are, for example, disposed opposite to each other. For instance, the third optical surface 116 is disposed on an opposite side of the first optical surface 112. That is to say, the light L enters through the opposite backside of the solar collector 110. Moreover, the area of the first optical surface 112 and an area of the third optical surface 116 are, for example, greater than the area of the second optical surface 114.

The light filter interface 340 is disposed on the third optical surface 116 of the solar collector 110. The light filter interface 340 allows light beyond the specific spectrum band to transmit the third optical surface 116. In other words, the light filter interface 340 has an anti-reflection design for the wavelength of solar spectrum that cannot be absorbed by the photovoltaic conversion material, for example. In one embodiment, the light filter interface 340 may be a coated film formed on the third optical surface 116, in which the coated film is, for example, a metal film or a non-metal film deposited by any methods. In another embodiment, the light filter interface 340 may be a plurality of microstructures formed on the third optical surface 116, in which the microstructures are, for example, nanoscale structures of any shape, such as moth-eye structures. By selecting the specific type of the coated film or the formative size of the microstructures, the anti-reflection property of the light filter interface 340 for the specific wavelength range can be adjusted. Accordingly, the light filter interface 340 can reflect the wavelength of light absorbable by the photovoltaic conversion material but only allow the wavelength of light that cannot be absorbed by the photovoltaic conversion material to transmit through the solar collector 110. As shown by FIG. 7, the light filter interface 340 is, for example, used as a longpass filter, in which the longpass filter has a transmittance of 0% for wavelength shorter than 800 nm, and only wavelength longer than 800 nm can transmit the longpass filter. Moreover, light of wavelength longer than 1000 mn has a preferable transmittance (approximately greater than 60%), and light of wavelength longer than 1107 nm has an even more preferable transmittance. Therefore, the longpass filter can be used to filter light with long wavelength.

Moreover, the heat absorber 332 of the cooling pipeline system 330 is connected to the second channel 136, and the light filter interface 340 is disposed between the third optical surface 116 and the heat absorber 332 of the cooling pipeline system 330. Therefore, the water flowing through the heat absorber 332 can absorb the light transmitting the light filter interface 340. In addition, a heat conduction plate 350 may be disposed between the light filter interface 340 and the heat absorber 332, for effectively absorbing the energy from the wavelength of light filtered and transmitting the light filter interface 340. Moreover, this absorbed energy can be uniformly transferred in the water flowing through the heat absorber 332. In one embodiment, the heat absorber 332 includes a plurality of channels distributed in the heat conduction plate 350 and forming a large area water circulating pipeline with the channels connected to each other, for example. In another embodiment, the heat absorber 332 may be an entire panel body as illustrated in FIG. 5, and the disclosure is not particularly limited thereto. A material of the heat absorber 332 includes a material with a high coefficient of thermal conductivity, such as a material with a coefficient of thermal conductivity of greater than 35 W/mK. In one embodiment, the heat absorber 332 includes a metal pipe, such as a copper pipe, for example. The heat conduction plate 350 is a black coated plate, for example. In one embodiment, a material of the heat conduction plate 350 includes a material with a high coefficient of thermal conductivity, such as a material with a coefficient of thermal conductivity of greater than 35 W/mK. In one embodiment, a material of the heat conduction plate 350 includes a metal.

In specifics, after the light L enters the solar collector 110 and before the light L exits the solar cell chip panel 120, the light filter interface 340 is used to first filter the light beyond the specific spectrum band absorbable by the photovoltaic conversion material. Moreover, the light L is transmitted through the solar collector 110 and the solar interface 340 and arrives at the heat absorber 332 of the cooling pipeline system 330. Accordingly, the water flowing through the heat absorber 332 can absorb the energy from the wavelength of light which cannot be absorbed by the photovoltaic conversion material. The residue light L' is reflected by the light filter interface 340 and continues to be collected in the solar collector 110, and thereafter the light L' enters the solar cell chip panel 120 to accordingly generate electricity. Since a portion of the energy of the wavelength of the residue light L' that causes the chip temperature to rise has been filtered by the light filter interface 340 before entering the solar cell chip panel 120, the lower temperature and high efficiency of the solar cell chip panel 120 can be maintained.

Experimental Example

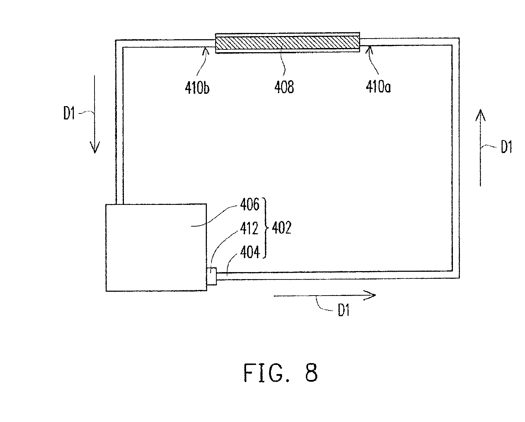

An experimental example is provided below to verify that the solar cell module in the embodiments of the disclosure can achieve the afore-described effects. The data results of the experimental example use a cooling pipeline system and an electric heater to simulate the cooling of the solar cell chip panel. The experimental example merely illustrates that the solar cell module in the embodiments of the disclosure can lower the chip temperature and transfer heat energy to the cooling pipeline system to heat cold water, and should not be construed as limiting the scope of the disclosure. FIG. 8 is a cooling pipeline system used in the experimental example of the disclosure, in which the electric heater is used to simulate the heating of the solar cell chip panel.

As shown in FIG. 8, a cooling pipeline system 402 includes a copper pipe channel 404 and a 5 liter storage tank 406 connected in series and forming a loop system. An electric heater 408 is disposed on a part of the channel 404, so the channel 404 is disposed below the electric heater 408 to simulate the solar cell chip panel 120 depicted in FIG. 1. The electric heater 408 has a dimension of 10 mm x 290 mm, a heat source power of approximately 31.69 W, and the electric heater 408 is temperature controlled to be under 55°C.

In the experimental example, the cooling pipeline system 402 further includes a pump 412 providing a power for the water flow. The pump 412 is used to guide the water from the storage tank 406 to flow into the channel 404 along a flow direction Dl. Moreover, the water flows below the electric heater 408 to absorb heat and then is circulated in the storage tank 406. A pump power used is 1.1 W, and this pump can drive the water to flow at a flow rate of 5.5 ml/sec in the channel 404 having a diameter of 6 mm. The experimental results listed in Table 1 below include results after 6 hours of continual testing. Moreover, at different time points, measurements are made for a water temperature at an inlet 410a before the water in the channel 404 flows through the electric heater 408, a water temperature at an outlet 410b after the water flows through the electric heater 408, a water temperature in the storage tank 406, and the heat absorbed by the water and the rate of heat loss are calculated. The rate of heat loss is defined as:

Rate of Heat Loss = ((Power of Electric Heater - Heat absorbed within the unit time during the water temperature increase) / Power of Electric Heater) x 100%

**Table 1**

| Time (Min) | Inlet Water Temp. (°C) | Outlet Water Temp. (°C) | Storage Tank Water Temp. (°C) | Heat Absorbed (W) | Rate of Heat Loss (%) |
|---|---|---|---|---|---|
| 0 | 25.5 | 25.9 | 26.6 | 9.2 | 70.9 |
| 20 | 27.0 | 28.1 | 27.9 | 25.3 | 20.1 |
| 40 | 28.3 | 29.3 | 29.2 | 23.0 | 27.3 |
| 60 | 29.8 | 31.0 | 30.7 | 27.6 | 12.8 |
| 80 | 31.0 | 32.1 | 31.8 | 25.3 | 20.1 |
| 100 | 32.1 | 33.1 | 32.9 | 23.0 | 27.3 |
| 120 | 33.1 | 34.2 | 34.0 | 25.3 | 20.1 |
| 140 | 34.0 | 35.1 | 34.9 | 25.3 | 20.1 |
| 160 | 34.8 | 36.0 | 35.7 | 27.6 | 12.8 |
| 180 | 35.7 | 36.7 | 36.6 | 23.0 | 27.3 |
| 200 | 36.7 | 37.7 | 37.6 | 23.0 | 27.3 |
| 220 | 37.6 | 38.8 | 38.5 | 27.6 | 12.8 |
| 240 | 38.3 | 39.4 | 39.2 | 25.3 | 20.1 |
| 260 | 38.9 | 39.8 | 39.7 | 20.7 | 34.6 |
| 280 | 39.3 | 40.4 | 40.2 | 25.3 | 20.1 |
| 300 | 39.7 | 40.8 | 40.6 | 25.3 | 20.1 |
| 320 | 40.2 | 41.1 | 41.1 | 20.7 | 34.6 |
| 340 | 40.7 | 41.8 | 41.5 | 25.3 | 20.1 |
| 360 | 41.2 | 42.3 | 42.0 | 25.3 | 20.1 |

As shown by the data in Table 1, after 6 hours of continual testing, the cooling pipeline system 402 can ramp up the temperature of the water in the 5 liter storage tank 406 from 25.4°C to 42°C. Moreover, the electric heater 408 can still maintain a temperature of under 48°C under a heat source providing 31.69 W of heat for 6 continuous hours. In addition, the experimental data of Table 1 can verify that the cooling pipeline system 402 can effectively convert the heat from the electric heater 408 into the cooling water. Moreover, the heat conversion efficiency can average over 70%, in which the heat conversion efficiency is defined as:

Heat Conversion Efficiency = 100% - Rate of Heat Loss

Moreover, using the same system depicted in FIG. 8 with 10 different sets of experimental parameters, the similar water temperatures are measured, and the heat absorbed by the water and the rate of heat loss are calculated. The experimental parameters and the data results are listed in Table 2. The variations in experimental parameters are the powers of heat source of different electric heaters 408 and the water mass flow rates in the channel 404.

**Table 2**

| Set | Power of Heat Source (W) | Mass Flow Rate (kg/s) | Inlet Water Temperature (°C) | Outlet Water Temperature (°C) | Heat Absorbed (W) | Rate of Heat Loss (%) |
|---|---|---|---|---|---|---|
| 1 | 31.6 | 8.17E-3 | 24.1 | 24.9 | 27.2 | 14 |
| 2 | 31 | 8.17E-3 | 27.6 | 28.3 | 23.9 | 23 |
| 3 | 30.87 | 6.11E-3 | 27.3 | 28.4 | 28 | 9 |
| 4 | 31 | 4.43E-3 | 27.5 | 29 | 27.8 | 10 |
| 5 | 30.4 | 8.17E-3 | 27 | 27.8 | 27.4 | 10 |
| 6 | 30.6 | 4.43E-3 | 23.6 | 25 | 26 | 15 |
| 7 | 31 | 8.266E-3 | 24.9 | 25.7 | 27.7 | 10 |
| 8 | 30.4 | 6.03E-3 | 25.7 | 26.8 | 27.8 | 8.6 |
| 9 | 29.8 | 22E-3 | 26.2 | 29.2 | 27.6 | 7.4 |
| 10 | 30 | 4.3E-3 | 26.3 | 27.8 | 27 | 10 |

As shown by the data in Table 2, under the different experimental conditions of 10 sets of varying heat source powers and water flow rates, the cooling pipeline system 402 can effectively convert the heat from the electric heater 408 into the cooling water, and the heat conversion efficiency can average over 80%.

As verified by the experimental results above, the cooling pipeline system can effectively prevent the overheat of the heat source. Accordingly, the issue of high temperature in the solar cell chip can be mitigated, and the power generation efficiency thereof can be increased. Meanwhile, the function of converting heat into the cooling water and thereby heating the cold water is achieved.

In view of the foregoing, in the solar cell modules of the embodiments above, before the sunlight enters the solar cell chip panel, the water flowing through the heat absorber in the cooling pipeline system is utilized to absorb the wavelength energy in the solar spectrum which cannot be converted by the photovoltaic conversion material into electricity. Accordingly, overheat in the solar chip after collecting the sunlight is mitigated, and the power generation efficiency is enhanced. Therefore, by using an active heat dissipation module such as the cooling pipeline system, not only is the overheat of the solar cell chip panel prevented, but the overall power generation of the solar chip is increased. Moreover, due to the heat dissipation process of the solar chip, the temperature of the water in the cooling pipeline system is ramped up, and the excess solar heat energy is converted into the function of heating water. Accordingly, not only can the solar cell module maintain the low temperature and high efficiency operating conditions of the solar cell chip, but at the same time, the residue heat is reused with further heat energy circulation. Therefore, the light energy and heat of the sun can be effectively utilized.

## Claims

1. A solar cell module (100, 200), comprising:
a solar collector (110) comprising a first optical surface (112) and a second optical surface (114), wherein a light (L, L') enters the solar collector (110) from the first optical surface (112), and then exits from the second optical surface (114) after collection;
a solar cell chip panel (120) having a light-receiving surface (122) for receiving the light (L, L') exited from the second optical surface (114), wherein the solar cell chip panel (120) comprises a photovoltaic conversion material absorbing a specific spectrum band in the light (L) and converting that into electricity; and
a cooling pipeline system (130, 230) allowing water to flow therein, comprising a heat absorber (132, 232), wherein the light (L') exits to the light-receiving surface (122) of the solar cell chip panel (120) through the heat absorber (132, 232), and the water flowing through the heat absorber (132, 232) absorbs light (L) beyond the specific spectrum band.

2. The solar cell module (100) as claimed in claim 1, wherein the heat absorber (132) is disposed between the second optical surface (114) of the solar collector (110) and the light-receiving surface (122) of the solar cell chip panel (120), so the light (L') exits to the light-receiving surface (122) from the second optical surface (114) after passing through the heat absorber (132).

3. The solar cell module (200) as claimed in claim 1, wherein the heat absorber (232) is disposed external to a space between the second optical surface (114) of the solar collector (110) and the light-receiving surface (122), so the light (L') enters the first optical surface (112) after passing through the heat absorber (232).

4. The solar cell module (200) as claimed in claim 3, wherein the heat absorber (232) is disposed at a plane on a same side of the first optical surface (112) of the solar collector (110).

5. The solar cell module (200) as claimed in claim 4, wherein the plane is perpendicular to the light-receiving surface (122) and parallel to the first optical surface (112).

6. The solar cell module (100, 200) as claimed in claim 1, wherein the photovoltaic conversion material comprises single crystal silicon, polysilicon, or amorphous silicon, and when the photovoltaic conversion material is a silicon-based material, the specific spectrum band is between 300 nm to 1107 nm.

7. The solar cell module (100, 200) as claimed in claim 1, wherein a material of the heat absorber (132, 232) is a material allowing light (L) of the specific spectrum band to transmit.

8. The solar cell module (100, 200) as claimed in claim 1, wherein the cooling pipeline system (130, 230) comprises:
a first channel (134) disposed on a side facing away from the light-receiving surface (122) of the solar cell chip panel (120);
a second channel (136) connected to the heat absorber (132, 232) and to the first channel (134); and
a storage tank (138) collected to the first channel (134) and the second channel (136) to form a loop, wherein after water having a first temperature flows from the storage tank (138) through the first channel (134), the second channel (136), and the heat absorber (132, 232) in sequence, the water reflows into the storage tank (138) and has a second temperature that is higher than the first temperature.

9. The solar cell module (100, 200) as claimed in claim 8, wherein the cooling pipeline system (130, 230) further comprises a pump (140) providing a power for the water flow.

10. The solar cell module (100, 200) as claimed in claim 1, wherein an area of the first optical surface (112) is greater than an area of the second optical surface (114).

11. The solar cell module (100, 200) as claimed in claim 1, wherein the first optical surface (112) is adjacent to the second optical surface (114).

12. A solar cell module (300), comprising:
a solar collector (110) comprising a first optical surface (112), a second optical surface (114), and a third optical surface (116), wherein a light (L) enters the solar collector (110) from the first optical surface (112), and then exits from the second optical surface (114) after collection;
a solar cell chip panel (120) having a light-receiving surface (122) for receiving the light (L') exited from the second optical surface (114), wherein the solar cell chip panel (120) comprises a photovoltaic conversion material absorbing a specific spectrum band in the light (L) and converting that into electricity;
a light filter interface (340) disposed on the third optical surface (116), allowing light (L) beyond the specific spectrum band to transmit the third optical surface (116); and
a cooling pipeline system (330) allowing water to flow therein, comprising a heat absorber (332), wherein the light filter interface (340) is disposed between the third optical surface (116) and the heat absorber (332), and the water flowing through the heat absorber (332) absorbs light (L) beyond the specific spectrum band.

13. The solar cell module (300) as claimed in claim 12, wherein the light filter interface (340) comprises a coated film or a plurality ofmicrostructures.

14. The solar cell module (300) as claimed in claim 12, further comprising a heat conduction plate (350) disposed between the light filter interface (340) and the heat absorber (332), wherein the heat conduction plate (350) is a black coated plate.

15. The solar cell module (300) as claimed in claim 12, wherein the photovoltaic conversion material comprises single crystal silicon, polysilicon, or amorphous silicon, and when the photovoltaic conversion material is a silicon-based material, the specific spectrum band is between 300 nm to 1107 nm.

16. The solar cell module (300) as claimed in claim 12, wherein the heat absorber (332) comprises a plurality of channels.

17. The solar cell module (300) as claimed in claim 12, wherein the cooling pipeline system (330) comprises:
a first channel (134) disposed on a side facing away from the light-receiving surface (122) of the solar cell chip panel (120);
a second channel (136) connected to the heat absorber (332) and to the first channel (134); and
a storage tank (138) connected to the first channel (134) and the second channel (136) to form a loop, wherein after water having a first temperature flows from the storage tank (138) through the first channel (134), the second channel (136), and the heat absorber (332) in sequence, the water reflows into the storage tank (138) and has a second temperature that is higher than the first temperature.

18. The solar cell module (300) as claimed in claim 17, wherein the cooling pipeline system (330) further comprises a pump (140) providing a power for the water flow.

19. The solar cell module (300) as claimed in claim 12, wherein an area of the first optical surface (112) and an area of the third optical surface (116) are greater than an area of the second optical surface (114).

20. The solar cell module (300) as claimed in claim 12, wherein the first optical surface (112) is adjacent to the second optical surface (114), the second optical surface (114) is adjacent to the third optical surface (116), and the first optical surface (112) and the third optical surface (116) are disposed opposite to each other.
